# EUROPÄISCHE PATENTSCHRIFT

(11) **EP 2 018 666 B1**
(45) Veröffentlichungstag und Bekanntmachung des Hinweises auf die Patenterteilung: **06.04.2011**
(21) Anmeldenummer: 07718446.3
(22) Anmeldetag: 15.05.2007
(51) Int. Cl.: H01L 23/498, H05K 1/18

(54) **VERFAHREN ZUM FESTLEGEN EINES ELEKTRONISCHEN BAUTEILS AUF EINER LEITERPLATTE, HERSTELLUNGVERFAHREN EINER TRÄGERLAGE UND EINER ZWISCHENLAGE, SOWIE SYSTEM BESTEHEND AUS EINER LEITERPLATTE UND WENIGSTENS EINEM ELEKTRONISCHEN BAUTEIL**
METHOD FOR FIXING AN ELECTRONIC COMPONENT ON A PRINTED CIRCUIT BOARD, MANUFACTURING METHOD OF A SUPPORT LAYER AND AN INTERPOSER LAYER, AND SYSTEM COMPRISING A PRINTED CIRCUIT BOARD AND AT LEAST ONE ELECTRONIC COMPONENT
PROCÉDÉ DE FIXATION D'UN COMPOSANT ÉLECTRONIQUE SUR UNE CARTE DE CIRCUIT IMPRIMÉ, PROCÉDÉ DE FABRICATION D'UNE COUCHE DE SUPPORT AINSI QUE D'UNE COUCHE D'INTERPOSITION, ET SYSTÈME CONSTITUÉ D'UNE CARTE DE CIRCUIT IMPRIMÉ ET D'AU MOINS UN COMPOSANT ÉLECTRONIQUE

(30) Priorität: 16.05.2006 AT 39306 U
(43) Veröffentlichungstag der Anmeldung: 28.01.2009
(73) Patentinhaber: AT & S Austria Technologie & Systemtechnik Aktiengesellschaft, 8700 Leoben-Hinterberg (AT)
(72) Erfinder: VORABERGER, Hannes, 8045 Graz (AT); SCHMID, Gerhard, 8793 Trofaiach (AT); RIESTER, Markus, 8054 Seiersberg (AT); STAHR, Johannes, 8600 Bruck (AT)
(74) Vertreter: Miksovsky, Alexander
(86) Internationale Anmeldenummer: PCT/AT2007/000234
(87) Internationale Veröffentlichungsnummer: WO 2007/131256

(56) Entgegenhaltungen:
- WO-A-01/43190
- US-A1- 2005 133 891
- US-A1- 2005 218 528
- US-A1- 2006 035 510
- US-B1- 6 335 491
- US-B1- 6 429 534

## Beschreibung

Die vorliegende Erfindung bezieht sich auf ein Verfahren zum Festlegen eines elektronischen Bauteils auf einer Leiterplatte bzw. Kontaktieren des elektronischen Bauteils mit der Leiterplatte, umfassend die folgenden Schritte:
- Bereitstellen der Leiterplatte mit einer Mehrzahl von Kontakt- bzw. Anschlußflächen
- Bereitstellen des elektronischen Bauteils mit einer der Mehrzahl von Kontakt- bzw. Anschlußflächen der Leiterplatte entsprechenden Anzahl von Kontakt- bzw. Anschlußstellen mit einem gegenüber dem Abstand der Kontakt- bzw. Anschlußflächen der Leiterplatte verringerten gegenseitigen Abstand, und
- Anordnen bzw. Ausbilden wenigstens einer Zwischenlage zum Entflechten der Kontakt- bzw. Anschlußstellen des elektronischen Bauteils zwischen den Kontakt- bzw. Anschlußflächen der Leiterplatte und den Kontakt- bzw. Anschlußstellen des elektronischen Bauteils.

Die Erfindung bezieht sich weiters auf ein Verfahren zur Herstellung einer Zwischenlage zum Entflechten von Kontakt- bzw. Anschlußstellen eines elektronischen Bauteils von Kontakt- bzw. Anschlußflächen einer Leiterplatte umfassend die folgenden Schritte:
- Bereitstellen der Leiterplatte mit einer Mehrzahl von Kontakt- bzw. Anschlußflächen;
- Ausbilden eines Basismaterials der Zwischenlage zumindest im Bereich der Kontakt- bzw. Anschlußflächen der Leiterplatte;
- Strukturieren der Zwischenlage zur Ausbildung von Leiterbahnen bzw. -strukturen und Kontaktstellen für ein Kontaktieren mit Kontakt- bzw. Anschlußflächen der Leiterplatte und mit Kontakt- bzw. Anschlußstellen eines an der Leiterplatte festzulegenden elektronischen Bauteils.

Die vorliegende Erfindung bezieht sich weiters auf ein System, umfassend eine Leiterplatte und wenigstens einen elektronischen Bauteil, wobei wenigstens eine Zwischenlage zum Entflechten von Kontakt- bzw. Anschlußstellen des elektronischen Bauteils und Kontakt- bzw. Anschlußflächen der Leiterplatte zwischen den Kontakt- bzw. Anschlußstellen des elektronischen Bauteils und den Kontakt- bzw. Anschlußflächen der Leiterplatte angeordnet bzw. ausgebildet ist, und wobei die Kontakt- bzw. Anschlußstellen des elektronischen Bauteils einen gegenüber den Kontakt- bzw. Anschlußstellen der Leiterplatte verringerten, gegenseitigen Abstand aufweisen.

Elektronische Bauteile, welche auf Leiterplatten aufzubringen sind, werden zunehmend komplexer, wobei dies vor allem in einem Anstieg der benötigten Anzahl von Verbindungen zu der Leiterplatte resultiert, welches bei gleichbleibender Größe des elektronischen Bauteils zu einer Reduzierung des Abstands zwischen einzelnen bzw. benachbarten Verbindungen, wie beispielsweise leitfähigen Stiften bzw. Pins führt. In diesem Zusammenhang wurde in der Leiterplattenfertigung dazu übergegangen, eine Entflechtung dieser Bauteile bzw. einzelner Bauteile über leitende Durchtritte bzw. Mikrovias über mehrere Leiterplattenlagen in sogenannten High Density Interconnects bzw. HDI-Leiterplatten durchzuführen.

Bei einer weiteren Zunahme der Komplexität elektronischer Bauteile und damit verbundener Erhöhung der Anzahl von Verbindungen zu einer Leiterplatte und/oder einer weiteren Verringerung der Abmessungen derartiger elektronischer Bauteile, welches ebenfalls zu einer Verringerung des Abstands zwischen benachbarten Verbindungen führt, wird für eine erforderliche Entflechtung eine große Zunahme der Anzahl von Leiterplattenlagen erwartet. Darüber hinaus minimiert die Zunahme der Komplexität eines derartigen elektronischen Bauteils mit einer mit einer Erhöhung der Verbindung verbundenen Reduktion des gegenseitigen Abstands die Möglichkeiten zum Durchführen bzw. Anordnen von Leiterbahnen bzw. Leiterstrukturen zwischen einzelnen Verbindungen bzw. macht eine Anordnung unmöglich, wobei dies unmittelbar zu einer weiteren Zunahme der Anzahl von erforderlichen Leiterplattenlagen führt. Zusätzliche Lagen einer derartigen Leiterplatte resultieren jedoch in einer Zunahme der Dicke der Leiterplatten und darüber hinaus in einer Steigerung der Produktionskosten.

Eine Möglichkeit zur Reduktion der Anzahl von Leiterplattenlagen liegt in der Verwendung von sehr feinen bzw. ultrafeinen Leiterstrukturen, wobei jedoch zum gegenwärtigen Zeitpunkt selbst bei gegebenenfalls bestehender Verfügbarkeit von Verfahren zur Herstellung derartiger feiner bzw. ultrafeiner Leiterstrukturen davon auszugehen ist, daß bei einer Produktion von mehrlagigen Leiterplatten mit derartigen ultrafeinen Leiterstrukturen in üblichen Produktionsformaten von High Density Interconnects, wie beispielsweise 18 x 24 Zoll, eine Ausrichtung von Leiterplattenlagen mit einer ausreichenden Präzision nicht möglich ist, um beispielsweise leitende Verbindungen zwischen einzelnen Leiterplattenlagen bei Vorsehen derartiger ultrafeiner Leiterbahnen bzw. Leiterstrukturen zur Verfügung zu stellen.

Aus der WO 01/43190 A1 ist eine Flüssigkristallanzeige bekannt geworden, wobei ein Substrat, welches Anschluß- bzw. Kontaktflächen aufweist, unter Einsatz einer zwischengeschalteten Vorrichtung mit einem elektronischen Bauteil gekoppelt bzw. verbunden wird.

Aus der US 2005/0133891 A1 ist ein aus einer Leiterplatte und einem elektronischen Bauteil bestehendes System bekannt geworden, wobei der elektronische Bauteil mit der Leiterplatte bzw. dem Substrat über zwischengeschaltete Anschlußstellen gekoppelt wird. Darüber hinaus ist der US 6,429,534 B1 ein rahmenförmiges Element für eine Kopplung zwischen einer Leiterplatte und einem auf der Leiterplatte festlegbaren, elektronischen Bauteil zu entnehmen, wobei das rahmenförmige Element den auf der Leiterplatte festgelegten, elektronischen Bauteil umgibt und eine Kopplung zwischen den Anschlußstellen des elektronischen Bauteils, welche von der Leiterplatte weggerichtet sind, und entsprechenden Anschluß- bzw. Kontaktflächen der Leiterplatte über Drahtverbindungen erfolgt, welche einerseits zwischen den Anschluß- bzw. Kontaktflächen des elektronischen Bauteils und entsprechenden Leiterbahnen auf dem rahmenförmigen Element und andererseits zwischen den Leiterbahnen auf dem rahmenförmigen Element und den entsprechenden Kontaktflächen der Leiterplatte vorgesehen sind.

Die vorliegende Erfindung zielt daher darauf ab, ausgehend von Verfahren der eingangs genannten Art sowie einem System der eingangs genannten Art die oben genannten Probleme im Hinblick auf einen Einsatz von eine größere Komplexität und/oder eine geringere Größe aufweisenden elektronischen Bauteilen mit einer damit verbundenen Reduzierung eines geringen wechselseitigen Abstands zwischen Verbindungen zur Leiterplatte bei im wesentlich unverändertem Aufbau einer Leiterplatte zu vermeiden und insbesondere unter Vermeidung von zusätzlich erforderlichen Leiterplattenlagen eine Entflechtung von derartigen hochkomplexen Bauteilen insbesondere geringer Größe zur Verfügung zu stellen.

Zur Lösung der oben genannten Aufgaben ist ein Verfahren zum Festlegen eines elektronischen Bauteils auf einer Leiterplatte bzw. Kontaktieren des elektronischen Bauteils mit der Leiterplatte der eingangs genannten Art im wesentlichen dadurch gekennzeichnet, daß nach Strukturierung der Zwischenlage eine zusätzliche Trägerlage zur Festlegung bzw. Kontaktierung des elektronischen Bauteils auf der Zwischenlage zur Entflechtung aufgebracht wird und mit Kontaktierungen für den elektronischen Bauteil versehen wird.

Da erfindungsgemäß nach einem Bereitstellen der Leiterplatte mit einer Mehrzahl von Kontakt- bzw. Anschlußflächen sowie einem Bereitstellen des elektronischen Bauteils mit einer entsprechenden Anzahl von Kontakt- bzw. Anschlußstelle eine bzw. wenigstens eine Zwischenlage zum Entflechten der Kontakt- bzw. Anschlußstellen des elektronischen Bauteils zwischen den Kontakt- bzw. Anschlußflächen der Leiterplatte und den zugehörigen Kontakt- bzw. Anschlußstellen des elektronischen Bauteils angeordnet bzw. ausgebildet wird, gelingt es, einen eine gegebenenfalls höhere Komplexität und damit verbunden eine höhere Anzahl von Verbindungen zur Leiterplatte bei gleichzeitig verringertem Abstand zwischen den einzelnen Verbindungen aufweisenden elektronischen Bauteil und/oder einen eine geringere Größe aufweisenden elektronischen Bauteil mit der Leiterplatte zu koppeln bzw. daran festzulegen oder diese zu kontaktieren, ohne die Anzahl von Leiterplattenlagen für eine Entflechtung zwischen den Anschlußstellen des elektronischen Bauteils und den Anschlußstellen bzw. -flächen der Leiterplatte zu erhöhen. Die erfindungsgemäß vorgesehene Zwischenlage kann eine gegenüber der Dicke einer Leiterplattenlage verringerte Dicke insbesondere der Dielektrikumsschicht aufweisen, so daß mit einer vernachlässigbaren Erhöhung der Dicke der gesamten Leiterplatte insbesondere unter Berücksichtigung der Tatsache, daß eine derartige Leiterplatte üblicherweise über eine Vielzahl von beispielsweise mehr als 4, insbesondere mehr als 6, Leiterplattenlagen verfügt, das Auslangen gefunden werden kann, wobei gleichzeitig eine sichere Entflechtung in einer bevorzugt einzigen Lage bzw. Schicht der Zwischenlage vorgenommen werden kann. Falls hochkomplexe Bauteile mit einer überaus großen Anzahl von Kontakt- bzw. Anschlußstellen zum Einsatz gelangen, kann mehr als eine Zwischenlage mit entsprechenden Durchkontaktierungen vorgesehen sein, wobei jedoch auch bei Vorsehen von mehr als einer Zwischenlage unter Berücksichtigung der gegenüber üblichen Leiterplattenlagen stark verringerten Dicke und der vereinfachten Strukturierung der Leiterplatte unverändert große Vorteile gegenüber dem Vorsehen von einer erhöhten Anzahl von zusätzlichen Leiterplattenlagen erzielbar sind. Für eine Aufnahme eines bzw. zur Erfüllung einer Trägerfunktion für einen in weiterer Folge an der Leiterplatte unter Zwischenschaltung der Zwischenlage zur Entflechtung festzulegenden elektronischen Bauteils wird erfindungsgemäß vorgeschlagen, daß nach Strukturierung der Zwischenlage eine zusätzliche Trägerlage zur Festlegung bzw. Kontaktierung des elektronischen Bauteils auf der Zwischenlage zur Entflechtung aufgebracht wird und mit Kontaktierungen für den elektronischen Bauteil versehen wird.

Es kann somit mit derzeit verfügbaren Techniken zum Ausbilden von eine Mehrzahl von Leiterplattenlagen aufweisenden Leiterplatten, insbesondere unter Berücksichtigung der Präzisionsanforderungen für ein Ausrichten einzelner Teilbereiche derartiger Leiterplattenlagen das Auslangen gefunden werden, während im Bereich der Zwischenlage für ein Entflechten entsprechende, sehr feine bzw. ultrafeine Leiterbahnen bzw. -strukturen vorgesehen sein können, während entsprechend große Teilbereiche bzw. Kontaktbereiche auf der Zwischenlage für eine jeweilige Kontaktierung bzw. Verbindung der Kontakt- bzw. Anschlußstellen des elektronischen Bauteils als auch der Anschluß- bzw. Kontaktflächen der Leiterplatten zur Verfügung gestellt werden können.

Wie oben bereits angedeutet, kann mit einer gegenüber üblichen Leiterplattenlagen eine vereinfachte Struktur aufweisenden Zwischenlage und zusätzlichen Trägerlage zum Entflechten das Auslangen gefunden werden, wobei in diesem Zusammenhang bevorzugt vorgeschlagen wird, daß die Zwischenlage mit Leiterbahnen bzw. -strukturen zwischen Kontaktbereichen entsprechend den Kontakt- bzw. Anschlußstellen des elektronischen Bauteils und entsprechend den Kontakt- bzw. Anschlußflächen der Leiterplatte ausgebildet wird. Da die Zwischenlage lediglich mit Leiterbahnen bzw. -strukturen zwischen Kontaktbereichen entsprechend den Kontakt- bzw. Anschlußstellen des elektronischen Bauteils und entsprechend den Kontakt- bzw. Anschlußflächen der Leiterplatte ausgebildet wird, kann eine Anordnung bzw. Ausbildung von sehr feinen bzw. ultrafeinen Leiterbahnen bzw. -strukturen vorgesehen sein, welche mit beispielsweise bekannten Techniken auf bzw. in der Zwischenlage ausgebildet werden können, so daß die bei Verwendung bzw. Einsatz von komplexen Bauteilen sich verringernden wechselweisen Abstände der Verbindungen derartiger Bauteile keine Beschränkungen im Hinblick auf Möglichkeiten zum Durchführen bzw. Vorsehen von Leiterbahnen in der Zwischenlage darstellen.

Für eine zuverlässige Kontaktierung zwischen dem elektronischen Bauteil und der Zwischenlage für eine Entflechtung wird gemäß einer weiters bevorzugten Ausführungsform vorgeschlagen, daß eine Kontaktierung zwischen den Kontakt- bzw. Anschlußstellen des elektronischen Bauteils und der Zwischenlage über Kontaktierungen des elektronischen Bauteils vorgenommen wird.

Gemäß einer abgewandelten Ausführungsform wird erfindungsgemäß bevorzugt vorgeschlagen, daß Kontakt- bzw. Anschlußstellen des elektronischen Bauteils direkt mit Kontaktbereichen der Zwischenlage kontaktiert werden, wodurch eine weitere Reduktion von Kosten bei der Festlegung des elektronischen Bauteils an der Leiterplatte und auch eine verbesserte Anbindung bzw. Festlegung von elektronischen Bauteilen auf einer Leiterplatte unter Zwischenschaltung der Zwischenlage zum Entflechten durch eine Reduktion von Verbindungen, beispielsweise Lötverbindungen oder Bondverbindungen erzielbar ist.

Gemäß einer weiters bevorzugten Ausführungsform wird vorgeschlagen, daß die Zwischenlage lediglich im Bereich der Kontakt- bzw. Anschlußflächen der Leiterplatte sowie der Kontakt- bzw. Anschlußstellen des elektronischen Bauteils ausgebildet wird, so daß mit entsprechend geringem Materialaufwand für die Ausbildung der Zwischenlage das Auslangen gefunden werden kann, da diese lediglich im Bereich der Festlegung des bzw. eines elektronischen Bauteils an der Leiterplatte unter gleichzeitiger Berücksichtung des größeren Abstands zwischen den einzelnen Anschluß- bzw. Kontaktflächen der Leiterplatte gegenüber dem Abstand der Kontakt- bzw. Anschlußstellen des elektronischen Bauteils vorgesehen sein muß.

Für eine weitere Kostenreduktion und/oder Ausbildung einer kompakten Gesamtstruktur insbesondere beim Zusammenbau des elektronischen Bauteils mit der Leiterplatte wird gemäß einer weiters bevorzugten Ausführungsform vorgeschlagen, daß der elektronische Bauteil mit von der Leiterplatte weg gerichteten Kontakt- bzw. Anschlußstellen auf der Leiterplatte festgelegt wird und von der Zwischenlage zum Entflechten und Verbinden mit den Kontakt- bzw. Anschlußflächen der Leiterplatten überlagert wird. Dadurch wird neben der Möglichkeit einer Entflechtung über die eine überaus geringe Dicke aufweisenden Zwischenlage auch eine Trägerfunktion für den elektronischen Bauteil erfüllt, so daß auf ein zusätzliches Trägersubstrat für den elektronischen Bauteil verzichtet werden kann, und somit nicht nur die Größe des von der Leiterplatte und dem wenigstens einen elektronischen Bauteil gebildeten Gesamtsystems verringert werden kann, sondern auch die Gesamtkosten reduziert werden können.

Zur Lösung der eingangs genannten Aufgaben ist darüber hinaus ein Verfahren zur Herstellung einer Zwischenlage zum Entflechten von Kontakt- bzw. Anschlußstellen eines elektronischen Bauteils von Kontakt- bzw. Anschlußflächen einer Leiterplatte der eingangs genannten Art im wesentlichen dadurch gekennzeichnet, daß nach Strukturierung der Zwischenlage eine zusätzliche Trägerlage zur Festlegung bzw. Kontaktierung des elektronischen Bauteils auf der Zwischenlage zur Entflechtung aufgebracht wird und mit Kontaktierungen für den elektronischen Bauteil versehen wird.

Wie oben bereits erwähnt, gelingt es nach Bereitstellen der Leiterplatte mit einer Mehrzahl von Kontakt- bzw. Anschlußflächen in einfacher Weise die wenigstens eine Zwischenlage für ein Entflechten für einen in weiterer Folge festzulegenden elektronischen Bauteil zur Verfügung zu stellen. Für eine Aufnahme eines bzw. zur Erfüllung einer Trägerfunktion für einen in weiterer Folge an der Leiterplatte unter Zwischenschaltung der Zwischenlage zur Entflechtung festzulegenden elektronischen Bauteils wird erfindungsgemäß vorgeschlagen, daß nach Strukturierung der Zwischenlage eine zusätzliche Trägerlage zur Festlegung bzw. Kontaktierung des elektronischen Bauteils auf der Zwischenlage zur Entflechtung aufgebracht wird und mit Kontaktierungen für den elektronischen Bauteil versehen wird.

Für eine zuverlässige Ausbildung der Zwischenlage, welche insbesondere sehr feine bzw. ultrafeine Leiterbahnen bzw. -strukturen aufweist, wird darüber hinaus vorgeschlagen, daß die Strukturierung der Zwischenlage über an sich bekannte Subtraktivtechniken, Semiadditivtechniken, Additivtechniken und/oder Prägetechniken bzw. Laserstrukturierungstechniken vorgenommen wird, wie dies einer bevorzugten Ausführungsform des erfindungsgemäßen Verfahrens zur Herstellung der Zwischenlage zum Entflechten entspricht.

Wie oben bereits erwähnt, kann insbesondere unter Berücksichtigung der Tatsache, daß die Zwischenlage zum Entflechten im wesentlichen lediglich sehr feine bzw. ultrafeine Leiterbahnen bzw. -strukturen neben den für eine Kontaktierung mit dem elektronischen Bauteil als auch der Leiterplatte vorzusehenden Kontaktbereichen enthält, bevorzugt vorgesehen sein, daß die Zwischenlage mit einer gegenüber der Dicke einer Leiterplattenlage verringerten Dicke ausgebildet wird.

In diesem Zusammenhang wird gemäß einer besonders bevorzugten Ausführungsform vorgeschlagen, daß die Dicke der Zwischenlage mit weniger als der Hälfte, insbesondere weniger als ein Drittel der Dicke einer Leiterplattenlage gewählt wird. Es läßt sich somit beispielsweise mit Zwischenlagen mit einer Dicke der Dielektrikumsschicht von unter beispielsweise 35 bis 40 µm, insbesondere bis zu 10 µm oder weniger, das Auslangen finden, während eine typische Dicke einer Dielektrikumsschicht einer HDI-Leiterplatte wenigstens 60 µm, beispielsweise mehr als 80 µm beträgt.

Für die Entflechtung der Verbindungsstelle bzw. Kontakt- bzw. Anschlußstellen des elektronischen Bauteils kann mit sehr feinen bzw. ultrafeinen Leiterstrukturen in der Zwischenlage das Auslangen gefunden werden, wobei in diesem Zusammenhang gemäß einer weiters bevorzugten Ausführungsform vorgeschlagen wird, daß die Zwischenlage mit Leiterbahnen bzw. Leiterstrukturen versehen wird, deren Breite mit weniger als 50 µm, insbesondere weniger als 30 µm gewählt wird.

Wie oben bereits angedeutet, kann insbesondere im Zusammenhang mit einer weiteren Kostenreduzierung und Vereinfachung der Ausbildung bzw. Festlegung des elektronischen Bauteils gemäß einer weiters bevorzugten Ausführungsform vorgesehen sein, daß die Zwischenlage als Träger und/oder Umhüllung für den elektronischen Bauteil verwendet wird.

Zur Lösung der eingangs genannten Aufgaben ist darüber hinaus ein System, welches eine Leiterplatte und wenigstens einen elektronischen Bauteil umfaßt, der eingangs genannten Art im wesentlichen dadurch gekennzeichnet, daß auf die Zwischenlage eine zusätzliche Trägerlage zur Festlegung bzw. Kontaktierung des elektronischen Bauteils auf der Zwischenlage zur Entflechtung aufgebracht ist und mit Kontaktierungen für den elektronischen Bauteil versehen ist. Es läßt sich somit lediglich durch Vorsehen wenigstens einer eine vergleichsweise geringe Dicke aufweisenden Zwischenlage zum Entflechten das Auslangen finden, wobei diese Zwischenlage, wie oben bereits angedeutet, bevorzugt lediglich partiell im Bereich der Kontakt- bzw. Anschlußflächen der Leiterplatte als auch der Kontakt- bzw. Anschlußstellen des damit zur verbindenden elektronischen Bauteils vorgesehen ist bzw. sein kann. Zur Vereinfachung der Festlegung bzw. Kontaktierung des elektronischen Bauteils wird erfindungsgemäß vorgeschlagen, daß auf die Zwischenlage eine zusätzliche Trägerlage zur Festlegung bzw. Kontaktierung des elektronischen Bauteils auf der Zwischenlage zur Entflechtung aufgebracht ist und mit Kontaktierungen für den elektronischen Bauteil versehen ist.

Gemäß einer bevorzugten Ausführungsform wird in diesem Zusammenhang vorgeschlagen, daß die Zwischenlage mit Leiterbahnen bzw. -strukturen zwischen Kontaktbereichen entsprechend den Kontakt- bzw. Anschlußstellen des elektronischen Bauteils und entsprechend den Kontakt- bzw. Anschlußflächen der Leiterplatte ausgebildet ist.

Wie bereits mehrfach angedeutet, kann bevorzugt vorgesehen sein, daß die Zwischenlage mit einer gegenüber der Dicke einer Leiterplattenlage verringerten Dicke ausgebildet ist, wobei gemäß einer besonders bevorzugten Ausführungsform vorgeschlagen wird, daß die Dicke der Zwischenlage weniger als die Hälfte, insbesondere weniger als ein Drittel der Dicke einer Leiterplattenlage beträgt.

Darüber hinaus wird bevorzugt vorgeschlagen, daß die Zwischenlage mit Leiterbahnen bzw. Leiterstrukturen versehen ist, deren Breite mit weniger als 50 µm, insbesondere weniger als 30 µm beträgt.

Zur Verwendung unverpackter elektronischer Bauteile bzw. zur Vereinfachung der Festlegung an einer Leiterplatte bzw. einer Kontaktierung mit dieser wird gemäß einer weiters bevorzugten Ausführungsform vorgeschlagen, daß die Zwischenlage als Träger und/oder Umhüllung für den elektronischen Bauteil verwendet ist.

Wie bereits mehrfach angedeutet, ist die erfindungsgemäße Zwischenlage zum Entflechten insbesondere im Zusammenhang mit eine Vielzahl von Leiterplattenlagen aufweisenden Leiterplatten bevorzugt einsetzbar bzw. verwendbar, wobei darüber hinaus vorgeschlagen wird, daß die Leiterplatte in an sich bekannter Weise mit einer Mehrzahl von übereinander angeordneten Leiterplattenlagen gebildet ist, welche wenigstens teilweise über einzelne Leiterplattenlagen verbindenden leitenden Durchtritte bzw. Mikrovias verbunden sind, wie dies einer weiteres bevorzugten Ausführungsform des erfindungsgemäßen Systems entspricht.

Die Erfindung wird nachfolgend anhand von in der beiliegenden Zeichnung schematisch dargestellten Ausführungsformbeispielen näher erläutert. In dieser zeigen:
Fig. 1 einen Teilschnitt durch ein erfindungsgemäßes System, bestehend aus einer Leiterplatte und einem daran festgelegten elektronischen Bauteil unter Verwendung einer erfindungsgemäßen Zwischenlage zum Entflechten;
Fig. 2 schematische Darstellungen einzelner Schritte zur Durchführung des erfindungsgemäßen Verfahrens zum Festlegen eines elektronischen Bauteils auf einer Leiterplatte unter Ausbildung bzw. Anordnung einer Zwischenlage zum Entflechten;
Fig. 3 schematisch einzelne Verfahrensschritte zur Ausbildung einer Zwischenlage zum Entflechten zum Einsatz in dem erfindungsgemäßen Verfahren bzw. im erfindungsgemäßen System;
Fig. 4 in einer zu Fig. 1 ähnlichen Darstellung eine detaillierte Darstellung eines elektronischen Bauteils eines erfindungsgemäßen Systems in gegenüber Fig. 1 verkleinertem Maßstab; s Fig. 5 in einer zu Fig. 4 ähnlichen Darstellung eines
Systems, das nicht im Schutzbereich der Erfindung liegt, wobei ein unverpackter elektronischer Bauteil integriert ist;
Fig. 6 in einer zu Fig. 4 und Fig. 5 ähnlichen Darstellung eine weitere abgewandelte Ausführungsform eines erfindungsgemäßen Systems, wobei der elektronische Bauteil unmittelbar auf der Zwischenlage zum Entflechten aufgebracht ist; und
Fig. 7 in einer wiederum zu Fig. 4 bis 6 ähnlichen Darstellung eine weitere abgewandelte Ausführungsform des erfindungsgemäßen Systems, wobei die Zwischenlage zum Entflechten auf einen in der Leiterplatte integrierten Bauteil aufgebracht ist.

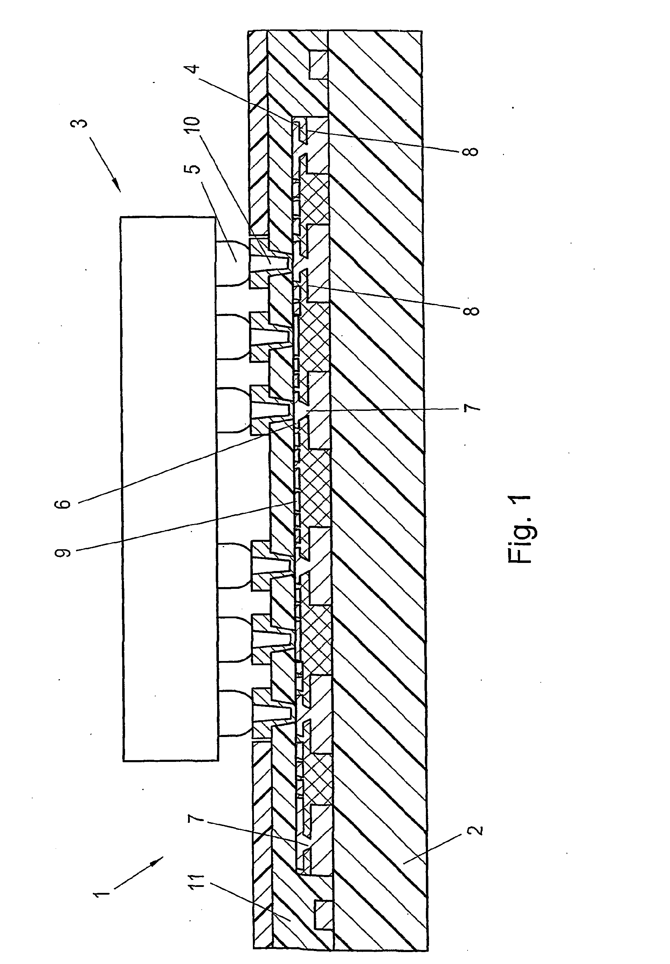

In Fig. 1 ist schematisch ein System 1 dargestellt, welches aus einer Leiterplatte, insbesondere einer eine Mehrzahl von Leiterplattenlagen aufweisenden HDI-Leiterplatte 2, und einem damit zu kontaktierenden bzw. daran festzulegenden elektronischen Bauteil 3 besteht, wobei zwischen dem elektronischen Bauteil 3 und der Leiterplatte 2 eine Zwischenlage 4 zum Entflechten angeordnet ist.

Wie aus Fig. 1 ersichtlich, weist die Zwischenlage 4 entsprechend der Anzahl von Kontakt- bzw. Anschlußstellen 5 des elektronischen Bauteils 3 eine Vielzahl von Kontakt- bzw. Anschlußbereichen 6 auf, welche entweder im wesentlichen direkt mit Kontakt- bzw. Anschlußbereichen 7 gekoppelt sind, welche Kontakt- bzw. Anschlußflächen 8 auf der Leiterplatte 2 entsprechen. Aus Fig. 1 ist ersichtlich, daß der Abstand zwischen benachbarten Anschluß- bzw. Kontaktstellen 5 des elektronischen Bauteils 3 geringer als der Abstand zwischen benachbarten Anschluß- bzw. Kontaktflächen 8 der Leiterplatte 2 ist, so daß für ein Entflechten in der Zwischenlage 4 zusätzlich sehr feine bzw. ultrafeine Leiterbahnen bzw. Leiterstrukturen vorgesehen sind, welche eine Verbindung mit weiteren Kontakt- bzw. Anschlußbereichen 7 der Zwischenlage 4 zur Verfügung stellen, über welche in weiterer Folge eine Kontaktierung mit Anschluß- bzw. Kontaktflächen 8 der Leiterplatte 2 erfolgt.

Im Gegensatz zum bekannten Stand der Technik, wo eine unmittelbare Kontaktierung zwischen den Anschluß- bzw. Kontaktstellen bzw. -verbindungen 5 des elektronischen Bauteils 3 mit zugeordneten Kontakt- bzw. Anschlußflächen 8 der Leiterplatte 2 gegebenenfalls unter Vorsehen von leitenden Durchtritten bzw. Mikrovias für eine Entflechtung der Anschluß- bzw. Verbindungsstellen 5 des hoch komplexen elektronischen Bauteils 3 erfolgt, wird bei der Ausbildung gemäß Fig. 1 die vollständige Entflechtung über die Zwischenlage 4 vorgenommen.

Bei der Ausbildung gemäß Fig. 1 ist die Zwischenlage 4 zum Entflechten lediglich im Bereich der Kontakt- bzw. Anschlußstellen 5 des elektronischen Bauteils 3 als auch der Kontakt- bzw. Anschlußflächen 7 der Leiterplatte 2 vorgesehen, so daß mit einer partiellen Ausbildung der Zwischenlage 4 das Auslangen gefunden werden kann.

Darüber hinaus ist in sämtlichen Figuren die Dicke der Zwischenlage gegenüber der Größe bzw. den Abmessungen sowohl der Leiterplatte 2 als auch des elektronischen Bauteils 3 nicht maßstabsgetreu dargestellt. Unter Berücksichtigung der sehr feinen bzw. ultrafeinen Leiterbahnen bzw. Leiterstrukturen 9, welche beispielsweise eine Breite von weniger als 50 µm, beispielsweise etwa 25 µm, aufweisen können, kann mit einer Dicke der Dielektrikumsschicht für die Zwischenlage 4 in der Größenordnung von etwa 35 µm das Auslangen gefunden werden, wobei dies weniger als die Hälfte einer üblichen Dicke der Dielektrikumsschicht einer Leiterplattenlage der Leiterplatte 2 ist. Darüber hinaus sind Dicken für die Dielektrikumsschicht der Zwischenlage 4 bis zu 10 µm oder darunter herstellbar bzw. einsetzbar.

Die in den Figuren dargestellte Leiterplatte 2 besteht darüber hinaus beispielsweise aus einer Mehrzahl von Leiterplattenlagen, welche jedoch nicht getrennt dargestellt bzw. angedeutet sind.

Bei der in Fig. 1 gezeigten Ausführungsform erfolgt die Kontaktierung zwischen der Zwischenlage 4 zum Entflechten und den Anschluß- bzw. Kontaktstellen 5 des Bauteils 3 über leitende bzw. leitfähige Kontaktierungen 10, welche in einer mit 11 schematisch angedeutete Trägerlage bzw. -struktur aufgenommen bzw. vorgesehen sind.

Anstelle der lediglich partiellen Anordnung der Zwischenlage 4 zum Entflechten entsprechend den Kontakt- bzw. Anschlußflächen 8 der Leiterplatte 2 sowie den Kontakt- bzw. Anschlußstellen 5 des elektronischen Bauteils 3 kann die Zwischenlage 4 bzw. insbesondere der Basismaterial derselben im wesentlichen vollflächig über der Leiterplatte 2 aufgetragen bzw. vorgesehen sein, wobei eine entsprechende Strukturierung mit den Kontaktbereichen 6 bzw. 7 als auch den Leiterbahnen 9 lediglich im Bereich der Festlegung bzw. der Kontaktierung des bzw. eines elektronischen Bauteils 3 an der Leiterplatte 2 vorgesehen bzw. ausgebildet wird.

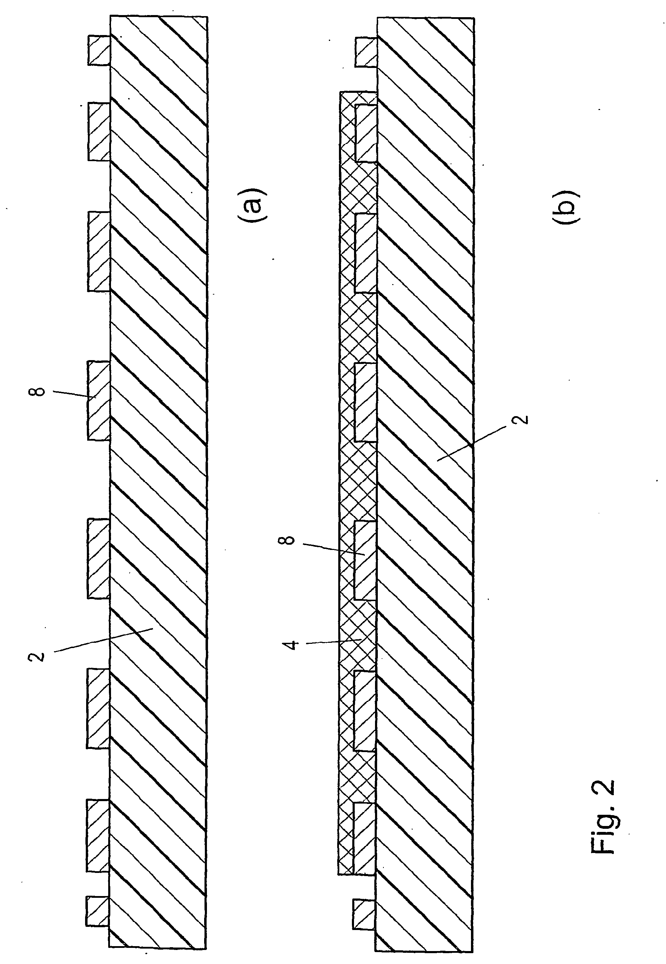

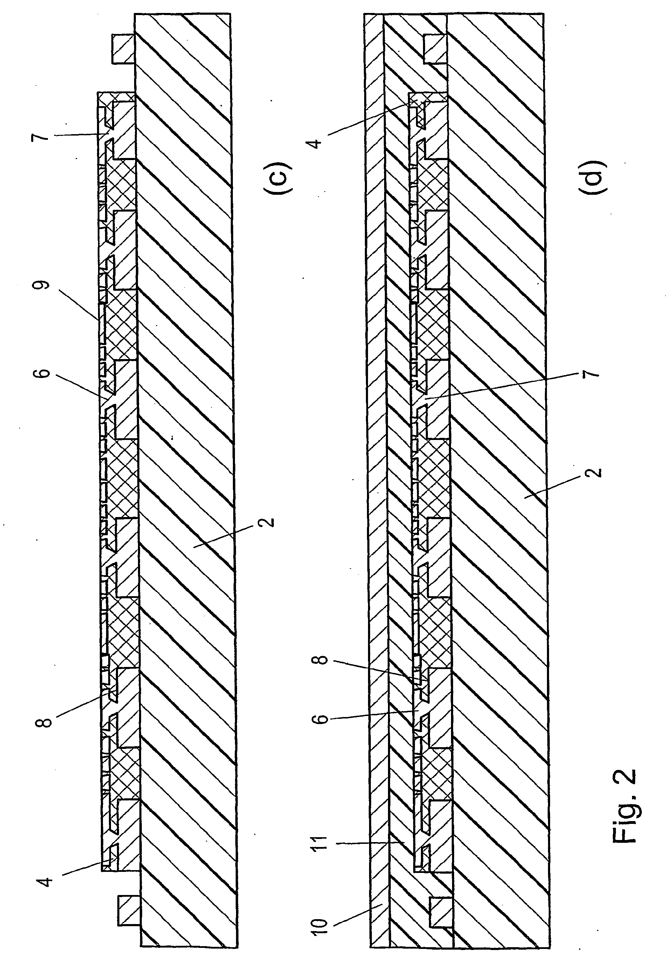

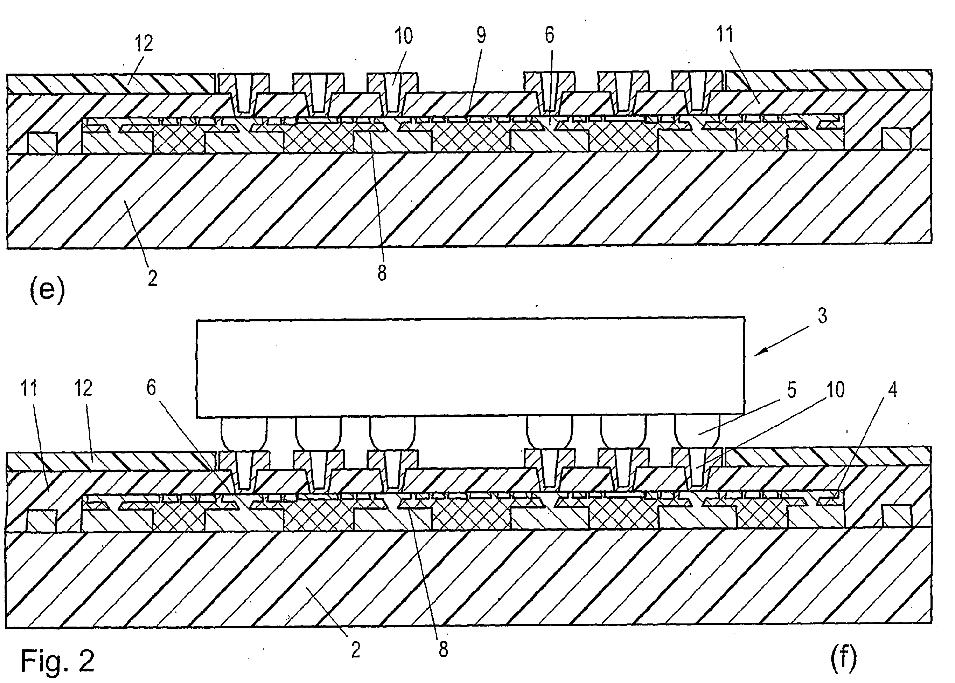

In Fig. 2 ist schematisch eine Verfahrensabfolge zur Herstellung eines aus einer Leiterplatte und einem elektronischen Bauteil bestehenden Systems 1 unter Verwendung bzw. Ausbildung einer Zwischenlage 4 zum Entflechten angedeutet.

In dem Schritt (a) wird eine Leiterplatte, insbesondere HDI-Leiterplatte 2 zur Verfügung gestellt, wobei entsprechende Anschluß- bzw. Kontaktflächen 8 bereits angedeutet bzw. ausgebildet sind.

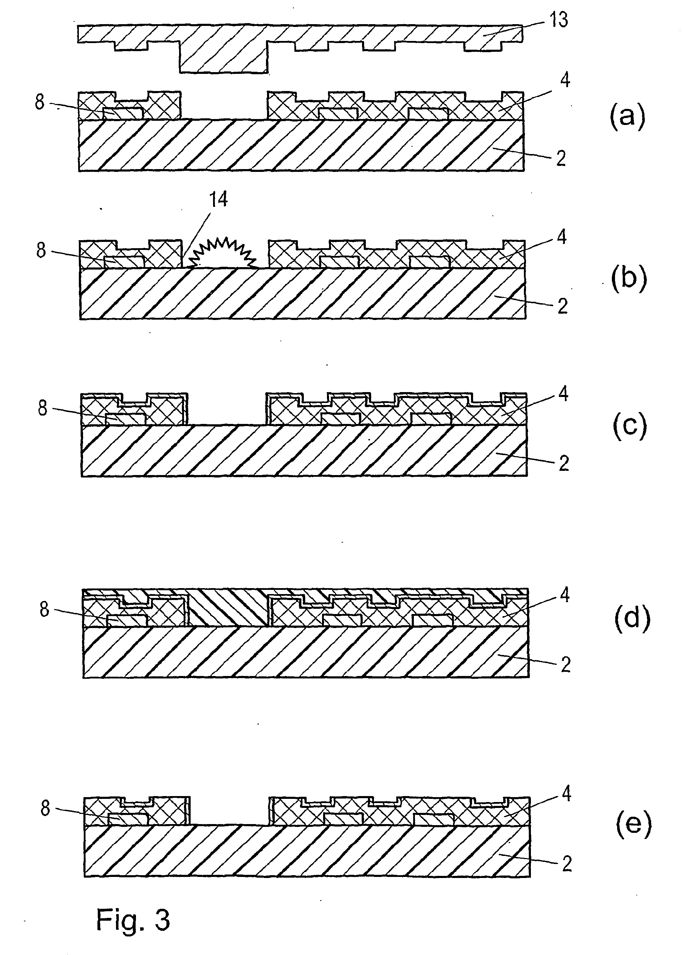

In Schritt (b) wird ein Basismaterial für die Zwischenlage 4 aufgebracht, worauf in Schritt (c) eine Strukturierung der Kontakt- bzw. Anschlußbereiche 6 bzw. 7 sowie der Leiterbahnen 9 der Zwischenlage 4 erfolgt, wobei ein beispielhaftes Verfahren zum Strukturieren der Zwischenlage 4 unter Bezugnahme auf Fig. 3 nachfolgend erörtert werden wird.

Nachfolgend auf die Strukturierung bzw. Ausbildung der Zwischenlage 4 zum Entflechten erfolgt gemäß Schritt (d) eine Aufbringung von zusätzlichen Lagen bzw. Trägerschichten 11 und 12, worauf in weiterer Folge gemäß Schritt (e) eine Strukturierung und Endfertigung der Trägerschichten bzw. -lagen 11 und 12, beispielsweise durch Vorsehen von Kontaktierungen 10 vorgenommen wird.

Abschließend wird in Schritt (f) der elektronische Bauteil 3 über die Anschluß- bzw. Kontaktstellen 5 und unter Zwischenschaltung der Kontaktierungen 10 mit der Zwischenlage 4 zum Entflechten und in weiterer Folge mit der Leiterplatte 2 gekoppelt bzw. verbunden.

In Fig. 3 sind schematische Teilschritte eines Verfahrens einer Strukturierung bzw. Ausbildung einer Zwischenlage 4 angedeutet, wobei beispielsweise eine an sich bekannte Prägetechnik zum Einsatz gelangt. Weiters ist anzumerken, daß für die Ausbildung bzw. Strukturierung der Zwischenlage 4 zum Entflechten lediglich eine einseitige Strukturierung im Gegensatz zu der in Fig. 3 allgemein angedeuteten, zweiseitigen Strukturierung einer Feinstleiterstruktur vorgenommen wird.

In einem Schritt (a) gemäß Fig. 3 erfolgt ein Prägen der Zwischenlage 4 beispielsweise unter Einsatz eines Prägewergzeugs 13, welches eine Reliefstruktur in eine Folie aus thermoplastischem Kunststoff prägt.

Gegebenenfalls bestehende Restmaterialien werden beispielsweise mittels reaktivem Ionenätzen in Schritt (b) entfernt, um eine Herstellung von durchgehenden Löchern bzw. Mikrovias 14 zu ermöglichen, worauf in weiterer Folge gemäß Schritt (c) ein Aufbringen einer Seed-Schicht aus einem dünnen leitenden Material über die gesamte Oberfläche erfolgt. Ein derartiges Aufbringen kann beispielsweise durch ein Sputtern oder thermisches Aufdampfen erfolgen.

Anschließend wird die Reliefstruktur gemäß Schritt (d) verkupfert und es wird das durch den Galvanisierungsprozeß aufgebaute überstehende Kupfer gemäß Schritt (e) beispielsweise durch chemische oder mechanische Methoden entfernt, so daß entsprechend der gewünschten Struktur der Zwischenlage 4 eine Ausbildung von Kontaktbereichen 6 bzw. 7 entsprechend der Position der Kontakt- bzw. Anschlußstellen 5 des elektronischen Bauteils 3 als auch der Kontakt- bzw. Anschlußfläche 8 der Leiterplatte 2 sowie der erforderlichen ultrafeinen Leiterbahnen 9 erzielbar sind.

Zur Herstellung der Zwischenlage 4 können thermoplastische Materialien, beispielsweise Polyetherimid, Liquid Crystal Polymer (LCP) verwendet werden.

Alternativ zur Verwendung von thermoplastischen Materialien können zur Strukturierung der Zwischenlage 4 thermisch bzw. UV-härtbare Materialien zum Einsatz gelangen.

Weiters kann anstelle der in Schritt (c) und (d) beschriebene Aufbringung einer leitfähigen Schicht ein Verfüllen der Vertiefungen bzw. Ausnehmungen mit einem leitfähigen Material vorgesehen sein.

Anstelle der Prägetechnik kann ein Abtragen des für die Zwischenschicht 4 eingesetzten Polymermaterials beispielsweise mittels Laserlicht vorgesehen sein.

Zum Strukturieren der Leiterplatte bzw. zum Anordnen der leitfähigen Anschluß- bzw. Kontaktbereiche 6 bzw. 7 als auch der Leiterbahn 9 können darüber hinaus an sich bekannte Substraktivtechniken, Semiadditivtechniken oder Additivtechniken eingesetzt werden.

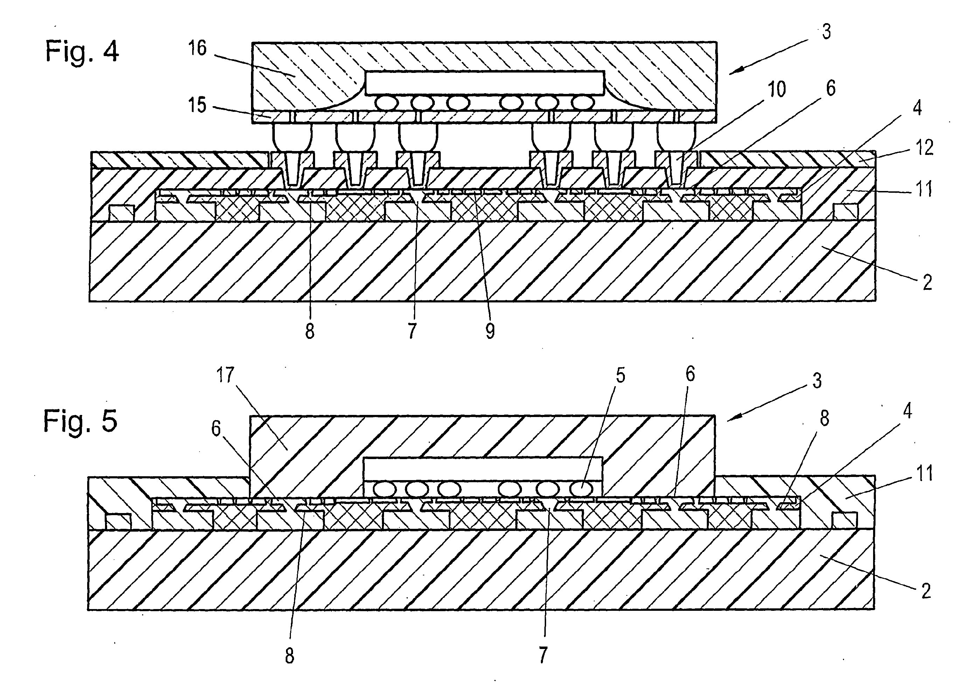

In den in Fig. 4, 6 und 7 dargestellten Ausführungsbeispielen und in dem in Fig. 5 dargestellte Beispiel, das nicht im Schutzbereich der Erfindung liegt, werden die Bezugszeichen der vorangehenden Figuren, insbesondere von Fig. 1 für jeweils gleiche Bauteile beibehalten.

Bei der Darstellung gemäß Fig. 4 erfolgt die Festlegung des elektronischen Bauteils 3 wiederum über Kontäktierurigen 10 an der Zwischenlage 4 für eine Kontaktierung mit der Leiterplatte 2, wobei in Fig. 4 ergänzend der elektronische Bauteil 3 in größerem Detail dargestellt ist und insbesondere ersichtlich ist, daß dieser auf einer plattenförmigen Trägerstruktur 15 angeordnet ist und von einer Ummantelung 16 umgeben ist.

Bei der abgewandelten Darstellung gemäß Fig. 5 ist ersichtlich, daß ein elektronischer Bauteil, welcher wiederum mit 3 bezeichnet ist, ohne die in Fig. 4 dargestellte Träger- und Ummantelungsstruktur 15 bzw. 16 eingesetzt wird, sondern direkt über wiederum mit 5 bezeichnete Anschluß- bzw. Kontaktstellen mit entsprechenden Kontaktbereichen 6 der Zwischenlage 4 zum Entflechten verbunden bzw. gekoppelt wird, über welche in weiterer Folge eine Verbindung bzw. ein Anschluß an die wiederum mit 2 bezeichnete Leiterplatte über die Anschluß- bzw. Kontaktflächen 8 erfolgt.

Bei der Ausbildung gemäß Fig. 5 dient die Zwischenlage 4 zum Entflechten darüber hinaus unmittelbar als Trägerstruktur und erfüllt somit eine Trägerfunktion für den elektronischen Bauteil 3, wodurch auf zusätzliche Kontaktierungen verzichtet werden kann. Dies führt zu einer Reduktion von Kosten und einer gleichzeitig verbesserten Anbindung des elektronischen Bauteils 3 an die Zwischenlage 4 und in weiterer Folge an die Leiterplatte 2.

Für eine ordnungsgemäße Festlegung bzw. zum Schutz des unverpackten Bauteils 3 ist bei der Ausführungsform gemäß Fig. 5 eine den elektronischen Bauteil 3 umgebende und an der Zwischenlage 4 zum Entflechten abgestützte Ummantelung 17 angedeutet.

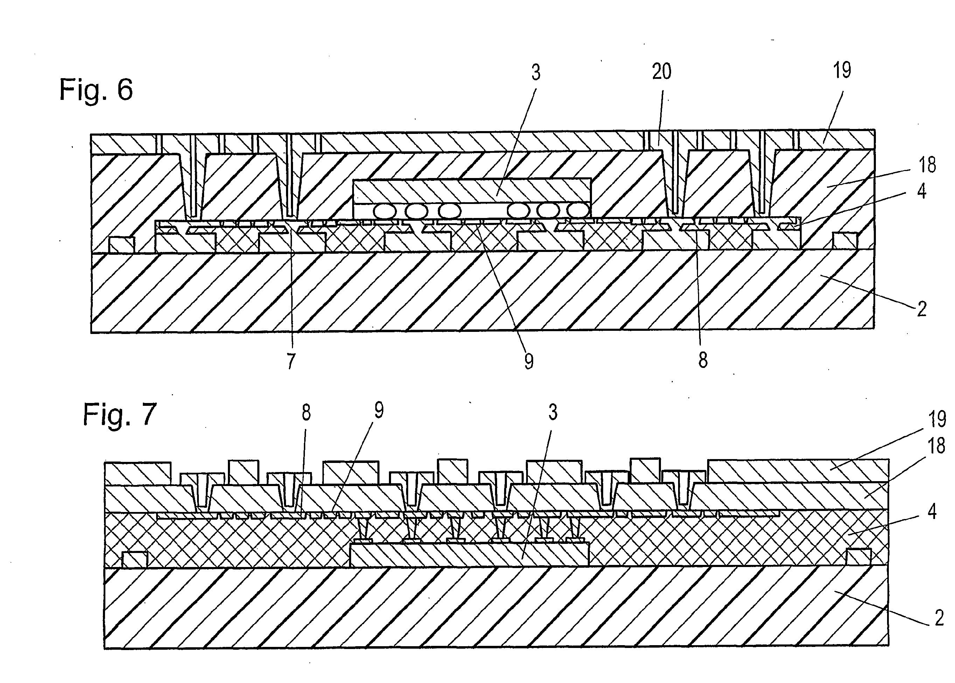

Bei der Ausführungsform gemäß Fig. 6 findet ein unverpackter elektronischer Bauteil 3 Verwendung, welcher unmittelbar mit der Zwischenlage 4 zum Entflechten gekoppelt ist. Über dem Bauteil 3 sind weitere Schichten 18 und 19 angedeutet, wobei insbesondere im Bereich dieser Schichten zusätzliche Kontaktierungen bzw. Verbindungen 20 angedeutet sind, welche für eine Festlegung weiterer Bauteile dienen, welche in Fig. 6 nicht gezeigt sind. Die Kontaktierung derartiger weiterer Bauteile über die Verbindungen bzw. Kontaktierungen 20 erfolgt auch bei der in Fig. 6 dargestellten Ausführungsform unter Zwischenschaltung der Zwischenlage 4 zum Entflechten.

Bei der in Fig. 7 dargestellten Ausführungsform ist der elektronische Bauteil 3 mit von der Leiterplatte 2 abgewandten Anschluß- bzw. Kontaktstellen angeordnet, wobei die Zwischenlage 4 zum Entflechten über dem elektronischen Bauteil 3 angeordnet ist und in weiterer Folge wiederum eine Kontaktierung mit Anschluß- bzw. Kontaktflächen 8 der Leiterplatte 2 erfolgt. Bei den Ausführungsformen gemäß Fig. 6 und 7 wird somit unmittelbar eine Integration des elektronischen Bauteils 3 ermöglicht, wobei dies zu einer weiteren Integration von eingebetteten Bauteilen und Erhöhung der Kompaktheit unter gleichzeitiger Verringerung der Gesamtgröße des Systems führt.

Durch die Verwendung der Zwischenlage 4 zum Entflechten zwischen den Anschluß- bzw. Kontaktstellen 5 des elektronischen Bauteils 3 als auch den Kontakt- bzw. Anschlußflächen 8 der Leiterplatte 2 kann somit mit einer eine geringe Dicke insbesondere der Dielektrikumsschicht insbesondere gegenüber der Dicke von üblichen Leiterplattenlagen aufweisenden Zwischenlage 4 das Auslangen gefunden werden, so daß insgesamt nur eine vernachlässigbare Erhöhung der Dicke der gesamten Leiterplatte erfolgt.

Weiters kann in den meisten Fällen mit einer einzigen Zwischenlage 4 zum Entflechten das Auslangen gefunden werden, wobei in dieser Zwischenlage 4 im Gegensatz zu üblichen Leiterplattenlagen lediglich Kontaktbereiche 6 bzw. 7 als auch sehr feine bzw. ultrafeine Leiterbahnen bzw. Leiterstrukturen 9 für eine Entflechtung vorgesehen sind, welche an die geringen Abstände von Verbindungen bzw. Anschlußstellen 5 hoch komplexer elektronischer Bauteile 3 anpaßbar sind, ohne daß für ein Entflechten derartiger hoch komplexer Bauteile 3 eine Vielzahl von Lagen, insbesondere zusätzlichen Leiterplattenlagen erforderlich wäre.

Bei Einsatz von eine überaus große Anzahl von Anschluß- bzw. Kontaktstellen aufweisenden, elektronischen Bauteilen 3, deren Anzahl einige hundert bis mehr als tausend betragen kann, kann darüber hinaus vorgesehen sein, daß über einer Zwischenlage 4 eine weitere Zwischenlage beispielsweise entsprechend dem in Fig. 3 schematisch erörterten Verfahren aufgebracht bzw. aufgetragen wird, wobei für eine Kontaktierung mit der darunterliegenden Leiterplatte 2 bzw. den die Leiterplatte 2 ausbildenden Leiterplattenlagen entsprechende Durchkontaktierungen bzw. Mikrovias vorgesehen sind. Unter Berücksichtigung der Tatsache, daß die Dicke der einer derartigen, gegebenenfalls erforderlichen, zusätzlichen Zwischenlage 4 wiederum gegenüber der Dicke einer zusätzlichen Leiterplattenlage, insbesondere deren Dielektrikumsschicht stark verringert ist, sowie weiter unter Berücksichtigung, daß aufgrund der vereinfachten Strukturierung einer derartigen Zwischenlage 4 zum Entflechten diese im wesentlichen lediglich sehr feine bzw. ultrafeine Leiterbahnenstrukturen 9 aufweist, kann selbst bei Vorsehen von mehr als einer Zwischenlage 4 zum Entflechten im Bereich hochkomplexer Bauteile 3 mit einer vernachlässigbaren Erhöhung der Gesamtdicke der Leiterplatte 2 gemeinsam mit den Zwischenlagen 4 das Auslangen gefunden werden. Im Gegensatz dazu muß berücksichtigt werden, daß bei einer gegebenenfalls angestrebten Entflechtung über zusätzliche Leiterplattenlagen aufgrund deren komplexerer Struktur gegenüber der einfachen Struktur der Zwischenlage 4 die Anzahl von Leiterplattenlagen beträchtlich erhöht werden müßte, so daß damit eine entsprechende Erhöhung der Gesamtdicke der Leiterplatte 2 als auch der Herstellungskosten verbunden wäre.

Darüber hinaus wird es durch das Vorsehen der dünnen Zwischenlage 4 möglich, größere Anschlußstellen bzw. -bereiche zur Verfügung zu stellen, wodurch die Anforderungen an die Registrationsgenauigkeit einzelner Lagen auch bei Einsatz von großformatigen Produktionsformaten von Leiterplatten, insbesondere HDI-Leiterplatten erfüllbar werden. Die eine sich verjüngende bzw. kegelförmige Struktur aufweisenden Bohrungen im Bereich von Durchtritten beanspruchen unter Berücksichtigung der verringerten Dicke einen geringen Platzbedarf und verringern somit die Anforderungen an die Registrierungs- bzw. Ausrichtgenauigkeit.

## Patentansprüche

1. Verfahren zum Festlegen eines elektronischen Bauteils (3) auf einer Leiterplatte (2) bzw. Kontaktieren des elektronischen Bauteils (3) mit der Leiterplatte (2), umfassend die folgenden Schritte:
- Bereitstellen der Leiterplatte (2) mit einer Mehrzahl von Kontakt- bzw. Anschlußflächen (8)
- Bereitstellen des elektronischen Bauteils (3) mit einer der Mehrzahl von Kontakt- bzw. Anschlußflächen (8) der Leiterplatte entsprechenden Anzahl von Kontakt- bzw. Anschlußstellen (5) mit einem gegenüber dem Abstand der Kontakt- bzw. Anschlußflächen (8) der Leiterplatte (2) verringerten gegenseitigen Abstand, und
- Anordnen bzw. Ausbilden wenigstens einer Zwischenlage (4) zum Entflechten der Kontakt- bzw. Anschlußstellen (5) des elektronischen Bauteils (3) zwischen den Kontakt- bzw. Anschlußflächen (8) der Leiterplatte (2) und den Kontakt- bzw. Anschlußstellen (5) des elektronischen Bauteils (3), **dadurch gekennzeichnet, daß** nach Strukturierung der Zwischenlage (4) eine zusätzliche Trägerlage (11) zur Festlegung bzw. Kontaktierung des elektronischen Bauteils (3) auf der Zwischenlage (4) zur Entflechtung aufgebracht wird und mit Kontaktierungen (10) für den elektronischen Bauteil (3) versehen wird.

2. Verfahren nach Anspruch 1, **dadurch gekennzeichnet, daß** die Zwischenlage (4) mit Leiterbahnen bzw. -strukturen (9) zwischen Kontaktbereichen entsprechend den Kontakt- bzw. Anschlußstellen (5) des elektronischen Bauteils (3) und entsprechend den Kontakt- bzw. Anschlußflächen (8) der Leiterplatte (2) ausgebildet wird.

3. Verfahren nach Anspruch 1 oder 2, **dadurch gekennzeichnet, daß** eine Kontaktierung zwischen den Kontakt- bzw. Anschlußstellen (5) des elektronischen Bauteils (3) und der Zwischenlage (4) über Kontaktierungen des elektronischen Bauteils (3) vorgenommen wird.

4. Verfahren nach einem der Ansprüche 1 bis 3, **dadurch gekennzeichnet, daß** die Zwischenlage (4) lediglich im Bereich der Kontakt- bzw. Anschlußflächen (8) der Leiterplatte (2) sowie der Kontakt- bzw. Anschlußstellen (5) des elektronischen Bauteils (3) ausgebildet wird.

5. Verfahren nach einem der Ansprüche 1 bis 4, **dadurch gekennzeichnet, daß** der elektronische Bauteil (3) mit von der Leiterplatte (2) weg gerichteten Kontakt- bzw. Anschlußstellen (5) auf der Leiterplatte (2) festgelegt wird und von der Zwischenlage (4) zum Entflechten und Verbinden mit den Kontakt- bzw. Anschlußflächen (8) der Leiterplatten (2) überlagert wird.

6. Verfahren zur Herstellung einer Trägerlage (11) und einer Zwischenlage (4) zum Entflechten von Kontakt- bzw. Anschlußstellen (5) eines elektronischen Bauteils (3) von Kontakt- bzw. Anschlußflächen (8) einer Leiterplatte (2), umfassend die folgenden Schritte:
- Bereitstellen der Leiterplatte (2) mit einer Mehrzahl von Kontakt- bzw. Anschlußflächen (8);
- Ausbilden eines Basismaterials der Zwischenlage (4) zumindest im Bereich der Kontakt- bzw. Anschlußflächen (8) der Leiterplatte (2);
- Strukturieren der Zwischenlage (4) zur Ausbildung von Leiterbahnen bzw. -strukturen (9) und Kontaktstellen (6, 7) für ein kontaktieren mit Kontakt- bzw. Anschlußflächen (8) der Leiterplatte (2) und mit Kontakt- bzw. Anschlußstellen (5) eines an der Leiterplatte (2) festzulegenden elektronischen Bauteils (3),
**dadurch gekennzeichnet, daß** nach Strukturierung der Zwischenlage (4) eine zusätzliche Trägerlage (11) zur Festlegung bzw. Kontaktierung des elektronischen Bauteils (3) auf der Zwischenlage (4) zur Entflechtung aufgebracht wird und mit Kontaktierungen (10) für den elektronischen Bauteil (3) versehen wird.

7. Verfahren nach Anspruch 6, **dadurch gekennzeichnet, daß** die Strukturierung der Zwischenlage (4) über an sich bekannte Subtraktivtechniken, Semiadditivtechniken, Additivtechniken und/oder Prägetechniken bzw. Laserstrukturierungstechniken vorgenommen wird.

8. Verfahren nach Anspruch 6 oder 7, **dadurch gekennzeichnet, daß** die Zwischenlage (4) mit Leiterbahnen bzw. Leiterstrukturen (9) versehen wird, deren Breite mit weniger als 50 µm, insbesondere weniger als 30 µm gewählt wird.

9. Verfahren nach einem der Ansprüche 6 bis 8, **dadurch gekennzeichnet, daß** die Zwischenlage (4) als Träger und/oder Umhüllung für den elektronischen Bauteil (3) verwendet wird.

10. System, umfassend eine Leiterplatte (2) und wenigstens einen elektronischen Bauteil (3), wobei wenigstens eine Zwischenlage (4) zum Entflechten von Kontakt- bzw. Anschlußstellen (5) des elektronischen Bauteils (3) und Kontakt- bzw. Anschlußflächen (8) der Leiterplatte (2) zwischen den Kontakt- bzw. Anschlußstellen (5) des elektronischen Bauteils (3) und den Kontakt- bzw. Anschlußflächen (8) der Leiterplatte (2) angeordnet bzw. ausgebildet ist, und wobei die Kontakt- bzw. Anschlußstellen (5) des elektronischen Bauteils (3) einen gegenüber den Kontakt-bzw. Anschlußstellen (8) der Leiterplatte (2) verringerten, gegenseitigen Abstand aufweisen, **dadurch gekennzeichnet, daß** auf die Zwischenlage (4) eine zusätzliche Trägerlage (11) zur Festlegung bzw. Kontaktierung des elektronischen Bauteils (3) auf der Zwischenlage (4) zur Entflechtung aufgebracht ist und mit Kontaktierungen (10) für den elektronischen Bauteil (3) versehen ist.

11. System nach Anspruch 10, **dadurch gekennzeichnet, daß** die Zwischenlage (4) mit Leiterbahnen bzw. -strukturen (9) zwischen Kontaktbereichen (6, 7) entsprechend den Kontakt- bzw. Anschlußstellen (5) des elektronischen Bauteils (3) und entsprechend den Kontakt- bzw. Anschlußflächen (8) der Leiterplatte (2) ausgebildet ist.

12. System nach Anspruch 10 oder 11, **dadurch gekennzeichnet, daß** die Zwischenlage mit Leiterbahnen bzw. Leiterstrukturen (9) versehen ist, deren Breite mit weniger als 50 µm, insbesondere weniger als 30 µm beträgt.

13. System nach einem der Ansprüche 10 bis 12, **dadurch gekennzeichnet, daß** die Zwischenlage (4) als Träger und/oder Umhüllung für den elektronischen Bauteil (3) verwendet ist.

14. System nach einem der Ansprüche 10 bis 13, **dadurch gekennzeichnet, daß** die Leiterplatte (2) in an sich bekannter Weise mit einer Mehrzahl von übereinander angeordneten Leiterplattenlagen gebildet ist, welche wenigstens teilweise über einzelne Leiterplattenlagen verbindenden leitenden Durchtritte bzw. Mikrovias verbunden sind.

## Claims

1. A process for attaching an electronic component (3) on a circuit board (2) and/or contacting the electronic component (3) with the circuit board (2), comprising the following steps:
- providing the circuit board (2) with a plurality of contact or connection surfaces (8),
- providing the electronic component (3) with a number of contact or connection sites (5) corresponding to the plurality of contact or connection surfaces (8) of the circuit board, at mutual distances reduced relative to the distances of the contact or connection surfaces (8) of the circuit board (2), and
- arranging or forming between the contact or connection surfaces (8) of the circuit board (2) and the contact or connection sites (5) of the electronic component (3) at least one intermediate layer (4) for disentangling the contact or connection sites (5) of the electronic component (3),
**characterized in that**, after the structuring of the intermediate layer (4), an additional support layer (11) for the attachment or contacting of the electronic component (3) is applied on the intermediate layer (4) for disentanglement and provided with contacts (10) for the electronic component (3).

2. A process according to claim 1, **characterized in that** the intermediate layer (4) is formed with conductive tracks or structures (9) between contact zones corresponding to the contact or connection sites (5) of the electronic component (3) and corresponding to the contact or connection surfaces (8) of the circuit board (2).

3. A process according to claim 1 or 2, **characterized in that** contacting between the contact or connection sites (5) of the electronic component (3) and the intermediate layer (4) is effected via contacts of the electronic component (3).

4. A process according to any one of claims 1 to 3, **characterized in that** the intermediate layer (4) is merely formed in the region of the contact or connection surfaces (8) of the circuit board (2) as well as the contact or connection sites (5) of the electronic component (3).

5. A process according to any one of claims 1 to 4, **characterized in that** the electronic component (3) is attached on the circuit board (2) with contact or connection sites (5) oriented away from the circuit board (2), and is overlaid by the intermediate layer (4) for disentanglement and connection to the contact or connection surfaces (8) of the circuit board (2).

6. A process for producing a support layer (11) and an intermediate layer (4) for disentangling contact or connection sites (5) of an electronic component (3) from contact or connection surfaces (8) of a circuit board (2), comprising the following steps:
- providing the circuit board (2) with a plurality of contact or connection surfaces (8);
- forming a base material of the intermediate layer (4) at least in the region of the contact or connection surfaces (8) of the circuit board (2);
- structuring the intermediate layer (4) to form conductive tracks or structures (9) and contact sites (6, 7) for contacting with contact or connection surfaces (8) of the circuit board (2) and with contact or connection sites (5) of an electronic component (3) to be attached on the circuit board (2),
**characterized in that**, after the structuring of the intermediate layer (4), an additional support layer (11) for the attachment or contacting of the electronic component (3) is applied on the intermediate layer (4) for disentanglement and provided with contacts (10) for the electronic component (3).

7. A process according to claim 6, **characterized in that** the structuring of the intermediate layer (4) is performed by subtractive techniques, semi-additive techniques, additive techniques and/or embossing techniques or laser structuring techniques known per se.

8. A process according to claim 6 or 7, **characterized in that** the intermediate layer (4) is provided with conductive tracks or conductive structures (9) whose widths are selected to be less than 50 µm, in particular less than 30 µm.

9. A process according to any one of claims 6 to 8, **characterized in that** the intermediate layer (4) is used as a support and/or enclosure for the electronic component (3).

10. A system including a circuit board (2) and at least one electronic component (3), wherein at least one intermediate layer (4) for the disentanglement of contact or connection sites (5) of the electronic component (3) from contact or connection surfaces (8) of the circuit board (2) is arranged or formed between the contact or connection sites (5) of the electronic component (3) and the contact or connection surfaces (8) of the circuit board (2), and wherein the contact or connection sites (5) of the electronic component (3) comprise mutual distances reduced relative to the contact or connection sites (8) of the circuit board (2), **characterized in that** an additional support layer (11) for the attachment and contacting of the electronic component (3) is applied on the intermediate layer (4) for disentanglement and provided with contacts (10) for the electronic component (3).

11. A system according to claim 10, **characterized in that** the intermediate layer (4) is formed with conductive tracks or structures (9) between contact zones (6, 7) corresponding to the contact or connection sites (5) of the electronic component (3) and corresponding to the contact or connection surfaces (8) of the circuit board (2).

12. A system according to claim 10 or 11, **characterized in that** the intermediate layer is provided with conductive tracks or conductive structures (9) whose widths are less than 50 µm, in particular less than 30 µm.

13. A system according to any one of claims 10 to 12, **characterized in that** the intermediate layer (4) is used as a support and/or enclosure for the electronic component (3).

14. A system according to any one of claims 10 to 13, **characterized in that** the circuit board (2) in a manner known per se is formed with a plurality of superimposed circuit board layers which are at least partially interconnected by conductive passages or microvias connecting individual circuit board layers.

## Revendications

1. Procédé pour la fixation d'un composant électronique (3) sur une carte de circuit imprimé (2) et/ou pour mettre en contact le composant électronique (3) avec la carte de circuit imprimé (2), comprenant les étapes suivantes :
- préparer la carte de circuit imprimé (2) avec une pluralité de surfaces de contact ou de connexion (8),
- préparer le composant électronique (3) avec un nombre de points de contact et/ou de connexion (5) correspondant à la pluralité des surfaces de contact et/ou de connexion (8) de la carte de circuit imprimé (2), ces points présentant un écart mutuel réduit par rapport à l'écart des surfaces de contact et/ou de connexion (8) de la carte de circuit imprimé (2), et
- disposer et/ou réaliser au moins une couche intermédiaire (4) pour le routage des points de contact et/ou de connexion (5) du composant électronique (3) entre les surfaces de contact et/ou de connexion (8) de la carte de circuit imprimé (2) et les points de contact et/ou de connexion (5) du composant électronique (3), **caractérisé en ce qu'**après la structuration de la couche intermédiaire (4) on applique une couche de support (11) supplémentaire pour la fixation du composant électronique (3) sur la couche intermédiaire (4) et/ou sa mise en contact avec celle-ci pour le routage en la garnissant de soudures (10) pour le composant électronique (3).

2. Procédé selon la revendication 1, **caractérisé en ce que** la couche intermédiaire (4) est réalisée avec des pistes et/ou structures conductrices (9) entre des zones de contact de manière correspondante aux points de contact et/ou de connexion (5) du composant électronique (3) et de manière correspondante aux surfaces de contact et/ou de connexion (8) de la carte de circuit imprimé (2).

3. Procédé selon la revendication 1 ou 2, **caractérisé en ce que** l'on procède à une mise en contact entre les points de contact et/ou de connexion (5) du composant électronique (3) et la couche intermédiaire (4) par l'intermédiaire de soudures du composant électronique (3).

4. Procédé selon l'une des revendications 1 à 3, **caractérisé en ce que** la couche intermédiaire (4) est seulement réalisée dans la zone des surfaces de contact et/ou de connexion (8) de la carte de circuit imprimé (2) ainsi qu'aux points de contact et/ou de connexion (5) du composant électronique (3).

5. Procédé selon l'une des revendications 1 à 4, **caractérisé en ce que** le composant électronique (3) est fixé sur la carte de circuit imprimé (2) avec des points de contact et/ou de connexion (5) orientés en opposition à la carte de circuit imprimé (2) et **en ce que** la couche intermédiaire (4) pour le routage et la connexion aux surfaces de contact et/ou de connexion (8) des cartes de circuit imprimés (2) se superpose à celui-ci.

6. Procédé pour la fabrication d'une couche de support (11) et d'une couche intermédiaire (4) pour le routage de points de contact et/ou de connexion (5) d'un composant électronique (3) de surfaces de contact et/ou de connexion (8) d'une carte de circuit imprimé (2), comprenant les étapes suivantes :
- préparer la carte de circuit imprimé (2) avec une pluralité de surfaces de contact et/ou de connexion (8) ;
- former un matériau de base de la couche intermédiaire (4) au moins dans la zone des surfaces de contact et/ou de connexion (8) de la carte de circuit imprimé (2) ;
- structurer la couche intermédiaire (4) pour la réalisation de pistes et/ou structures conductrices (9) et de points de contact (6, 7) pour une mise en contact avec des surfaces de contact et/ou de connexion (8) de la carte de circuit imprimé (2) et avec des points de contact et/ou de connexion (5) d'un composant électronique (3) à fixer sur la carte de circuit imprimé (2),
**caractérisé en ce qu'**après la structuration de la couche intermédiaire (4) on applique une couche de support (11) supplémentaire pour la fixation du composant électronique (3) sur la couche intermédiaire (4) et/ou sa mise en contact avec celle-ci pour le routage en la garnissant de soudures (10) pour le composant électronique (3).

7. Procédé selon la revendication 6, **caractérisé en ce que** la structuration de la couche intermédiaire (4) est réalisée à l'aide de techniques soustractives, techniques semi-additives, techniques additives et/ou techniques de gravure et/ou techniques de structuration au laser connues par ailleurs.

8. Procédé selon la revendication 6 ou 7, **caractérisé en ce que** la couche intermédiaire (4) est garnie de pistes conductrices et/ou structures conductrices (9), dont la largeur est choisie de manière à être inférieure à 50 µm, en particulier inférieure à 30 µm.

9. Procédé selon l'une des revendications 6 à 8, **caractérisé en ce que** la couche intermédiaire (4) est utilisée en tant que support et/ou enveloppe pour le composant électronique (3).

10. Système comprenant une carte de circuit imprimé (2) et au moins un composant électronique (3), au moins une couche intermédiaire (4) pour le routage de points de contact et/ou de connexion (5) du composant électronique (3) et de surfaces de contact et/ou de connexion (8) de la carte de circuit imprimé (2) étant disposée et/ou réalisée entre les points de contact et/ou de connexion (5) du composant électronique (3) et les surfaces de contact et/ou de connexion (8) de la carte de circuit imprimé (2), et les points de contact et/ou de connexion (5) du composant électronique (3) présentant un écart mutuel réduit par rapport à l'écart des points de contact et/ou de connexion (8) de la carte de circuit imprimé (2), **caractérisé en ce que** l'on applique sur la couche intermédiaire (4) une couche de support (11) supplémentaire pour la fixation du composant électronique (3) sur la couche intermédiaire (4) et/ou sa mise en contact avec celle-ci pour le routage en la garnissant de soudures (10) pour le composant électronique (3).

11. Système selon la revendication 10, **caractérisé en ce que** la couche intermédiaire (4) est réalisée avec des pistes et/ou structures conductrices (9) entre des zones de contact (6, 7) de manière correspondante aux points de contact et/ou de connexion (5) du composant électronique (3) et de manière correspondante aux surfaces de contact et/ou de connexion (8) de la carte de circuit imprimé (2).

12. Système selon la revendication 10 ou 11, **caractérisé en ce que** la couche intermédiaire est garnie de pistes et/ou structures conductrices (9) dont la largeur est inférieure à 50 µm, en particulier inférieure à 30 µm.

13. Système selon l'une des revendications 10 à 12, **caractérisé en ce que** la couche intermédiaire (4) est utilisée en tant que support et/ou enveloppe pour le composant électronique (3).

14. Système selon l'une des revendications 10 à 13, **caractérisé en ce que** la carte de circuit imprimé (2) est réalisée de manière connue par ailleurs avec une pluralité de couches de carte de circuit imprimé disposées les unes au-dessus des autres, lesquelles sont reliées au moins partiellement via des passages et/ou trous microvias conducteurs reliant des couches de carte de circuit imprimé individuelles.
